Europäisches Patentamt

(19) European Patent Office

Office européen des brevets

(11) Numéro de publication : **0 029 767**
**B1**

(12) **FASCICULE DE BREVET EUROPÉEN**

(45) Date de publication du fascicule du brevet :
24.08.83

(51) Int. Cl.³ : **H 03 K 17/06**, H 03 K 17/12

(21) Numéro de dépôt : **80401599.8**

(22) Date de dépôt : **07.11.80**

(54) **Procédé de commande d'un montage Darlington et montage Darlington à faibles pertes.**

(30) Priorité : **23.11.79 FR 7928979**

(43) Date de publication de la demande :
**03.06.81 Bulletin 81/22**

(45) Mention de la délivrance du brevet :
**24.08.83 Bulletin 83/34**

(84) Etats contractants désignés :
**DE FR GB IT NL**

(56) Documents cités :
**US A 3 889 137**
**US A 4 028 561**

**IBM TECHNICAL DISCLOSURE BULLETIN,
vol. 15, no 12, mai 1973 New York US WIEDMAN :
« Saturation controlled transistors », page 3798**

**ELECTRONICS, vol. 38, no 16, 9 août 1965 New
York US CIANCIOLA : « Improving Darlington
speed », page 83**

(73) Titulaire : **THOMSON-CSF
173, Boulevard Haussmann
F-75379 Paris Cedex 08 (FR)**

(72) Inventeur : **Rischmueller, Klaus
"THOMSON-CSF" SCPI 173, bld Haussmann
F-75360 Paris Cedex 08 (FR)**

(74) Mandataire : **de Beaumont, Michel et al
THOMSON-CSF SCPI 173, Bld Haussmann
F-75379 Paris Cedex 08 (FR)**

**Procédé de commande d'un montage Darlington et montage Darlington à faibles pertes**

La présente invention concerne un montage de transistors de type Darlington à faibles pertes et plus particulièrement un tel montage dans lequel le transistor de puissance peut fonctionner alternativement en transistor indépendant ou en montage Darlington.

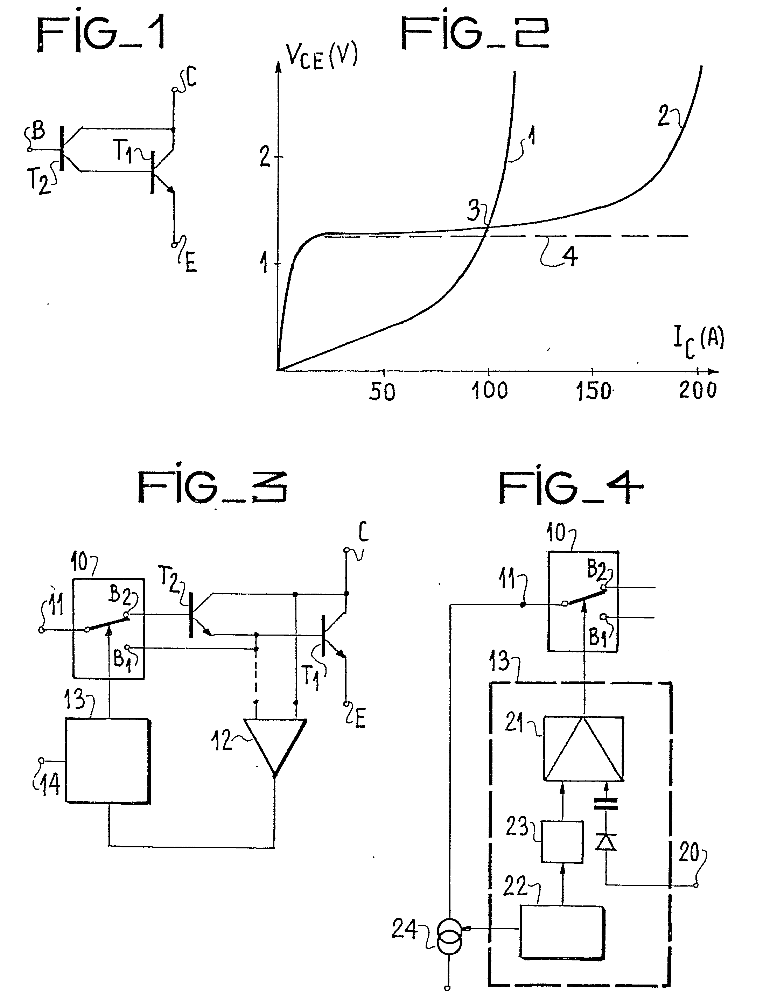

La figure 1 rappelle la structure d'un montage Darlington de deux transistors. Ce montage comprend un transistor de puissance ou transistor principal $T_1$ et un transistor auxiliaire ou transistor pilote $T_2$. Les collecteurs de ces deux transistors sont interconnectés et la base du transistor principal est connectée à l'émetteur du transistor pilote. Cet ensemble comprend trois bornes de connexion, une borne de collecteur C correspond à la borne de collecteur $C_1$ du transistor principal, une borne d'émetteur E correspond à la borne d'émetteur $E_1$ du transistor principal et une borne de commande B correspond à la base $B_2$ du transistor pilote. De façon générale, on désignera dans ce qui suit sans indice les bornes correspondant au montage d'ensemble, avec l'indice 1 les bornes correspondant au transistor principal $T_1$ et avec l'indice 2 les bornes correspondant au transistor pilote $T_2$. Un montage Darlington tel que représenté en figure 1 peut être réalisé sous forme de structure intégrée sur un substrat semiconducteur ou sous forme d'une association de composants discrets. Dans tous les cas, le transistor principal $T_1$ est un transistor de forte puissance devant le transistor $T_2$.

Les avantages du montage Darlington sont bien connus et résident essentiellement dans le fait que ce montage permet de mettre en conduction à l'état de saturation le transistor principal $T_1$ avec un courant de base beaucoup plus faible que celui qui serait néc ssaire en l'absence du transistor $T_2$.

Dans le cadre de la présente invention, on va examiner plus particulièrement un inconvénient du montage Darlington à savoir que, pour une gamme de courant que le transistor $T_1$ pourrait supporter seul, la chute de tension en direct est plus élevée dans le cas du montage Darlington que dans le cas où ce transistor $T_1$ est monté seul.

On s'intéressera ici essentiellement au cas des transistors de puissance fonctionnant en commutation, c'est-à-dire dans lesquels le courant de base est suffisamment élevé pour que l'on fonctionne toujours en régime de saturation vraie.

Ainsi, si on considère un transistor tel que le transistor $T_1$ monté indépendamment dans lequel on veut obtenir un courant de collecteur $I_{CI}$ de 50 A, le courant de base devra être, pour qu'on soit dans un état de saturation vraie, d'environ 2,5 ampères alors que la chute de tension en direct entre le collecteur et l'émetteur sera sensiblement $V_{CE\ sat} = 0,4$ volt. Si l'on cherche à faire fonctionner dans les mêmes conditions, c'est-à-dire avec un courant de collecteur d'environ 50 ampères, le transistor $T_1$ associé en Darlington avec le transistor $T_2$, le courant de base ne devra être que de 0,5 A mais la chute de tension en direct sera supérieure à 1 volt. La diminution du courant de base dans cette gamme de valeurs n'est pas un avantage notable alors que l'augmentation de la chute de tension en direct constitue un inconvénient marqué. En effet, elle correspond à la consommation dans le transistor, c'est-à-dire à des pertes thermiques. Par contre, si l'on voulait faire fonctionner le transistor $T_1$ avec un courant de collecteur très élevé de l'ordre de 150 A, ceci serait impossible en raison de l'augmentation très rapide de la chute de tension en direct dans ce transistor et d'autre part, même si c'était possible, nécessiterait la fourniture d'un courant de base très important, par exemple de l'ordre de 30 ampères. Par contre, avec un montage en Darlington, pour un courant de collecteur de 150 A, on pourrait travailler en saturation avec un courant de base raisonnable de l'ordre de 2 A, et la chute de tension en direct, serait inférieure à 1,8 volt.

La figure 2 illustre des caractéristiques de chute de tension en direct ($V_{CE}$) en fonction du courant de collecteur ($I_C$) pour un transistor indépendant (courbe 1) et pour l'association en Darlington de ce même transistor avec un transistor pilote (courbe 2). Les courants de base ne sont pas indiqués mais sont supposés être tels que le transistor de puissance fonctionne toujours dans l'état de saturation vraie. Sur les axes de coordonnées de la figure 2 ont été indiquées des valeurs numériques pour faciliter la compréhension mais ces valeurs numériques ne doivent pas être interprétées comme donnant une indication limitative sur la portée de l'invention. Les courbes 1 et 2 se coupent en un point d'intersection 3. Pour des valeurs du courant de collecteur supérieures à la valeur correspondant au point 3 (100 A dans l'exemple choisi), il est clair que seul le fonctionnement en Darlington est possible et c'est pour cette raison que l'on utilise habituellement les montages de type Darlington. Pour des valeurs du courant collecteur inférieures à celles correspondant au point 3, les courbes de la figure 2 montrent clairement que la consommation ou chute de tension en direct du transistor en montage indépendant est nettement inférieure à celle du même transistor en montage Darlington. En outre, pour cette gamme de valeur, les courants de base nécessaires pour mettre dans le régime de saturation vraie un transistor indépendant restent raisonnables. Ainsi, c'est un aspect de la présente invention que d'avoir nettement fait ressortir ce phénomène illustré dans la figure 2 à savoir qu'il est intéressant, en ce qui concerne la chute de tension en direct, d'avoir un fonctionnement en transistor indépendant pour une première gamme de valeurs du courant de collecteur puis un fonctionnement en Darlington pour des valeurs plus élevées de ce courant de collecteur.

Pour résoudre ce problème, la présente invention prévoit de détecter le courant de collecteur dans le transistor de puissance d'un montage Darlington, de comparer ce courant de collecteur à une valeur de seuil, et de faire fonctionner indépendamment le transistor de puissance quand la valeur dudit courant de collecteur est inférieure au seuil prédéterminé.

La détection du courant de collecteur n'est de préférence pas faite directement mais plutôt par détection d'une variable correspondante telle que la tension collecteur/émetteur du transistor principal.

Plus particulièrement, la présente invention prévoit un montage de transistor de type Darlington dans lequel la base du transistor pilote et la base du transistor de puissance sont reliées respectivement à une première borne de commande et à une deuxième borne de commande, ce montage comprenant en outre un moyen de commutation susceptible de recevoir à sa borne d'entrée un courant de commande et transmettant ce courant soit à la première borne de commande soit à la deuxième borne de commande ; un moyen de détection et de comparaison du courant traversant le transistor de puissance ; et des moyens de commande pour actionner le moyen de commutation vers la première ou la deuxième borne de commande selon que le moyen de détection indique que le courant dans le transistor de puissance est supérieur ou inférieur à un seuil prédéterminé. Dans un mode de réalisation le moyen de détection et de comparaison détecte la tension de collecteur du transistor de puissance et la compare à une tension fixe prédéterminée. Au lieu d'effectuer la comparaison par rapport à une tension fixe prédéterminée, on pourra comparer la tension de collecteur du transistor de puissance à sa tension de base, le résultat de cette comparaison étant lui-même comparé à une valeur de seuil.

On pourrait envisager d'autres approches pour rendre le fonctionnement du transistor principal du montage Darlington indépendant du transistor pilote. Par exemple, on pourrait disposer un interrupteur tel qu'un transistor en série entre les bornes de collecteur du transistor pilote et du transistor de puissance. Il conviendrait alors d'ouvrir ce transistor série quand le courant dans le transistor principal devient inférieur à un seuil prédéterminé. Néanmoins, si cette solution paraît possible dans le cas de composants discrets, elle ne paraît pas réalisable dans le cas d'un montage Darlington intégré dans lequel la borne de collecteur du transistor pilote n'est pas accessible indépendamment de la borne de collecteur du transistor principal. En outre, dans le cas où le montage est possible, c'est-à-dire en composants discrets, le transistor supplémentaire inséré en série avec la borne de collecteur du transistor pilote crée une chute de tension accrue entre les bornes de collecteur et d'émetteur du montage quand celui-ci est en fonctionnement Darlington.

Une autre approche à la solution du problème posé consisterait à utiliser d'une part un montage Darlington, d'autre part, un transistor indépendant équivalent au transistor principal du montage Darlington et à commander alternativement le montage Darlington et le transistor indépendant selon le courant collecteur. L'inconvénient évident de cette méthode est d'obliger à une duplication du nombre des composants de puissance.

Les caractéristiques et avantages de la présente invention seront exposés en détail dans la description suivante des modes de réalisation particuliers, faite en relation avec les figures jointes parmi lesquelles :

la figure 1 représente un montage Darlington classique ;

la figure 2 représente des courbes caractéristiques de la chute de tension en direct ($V_{CE}$) en fonction du courant de collecteur ($I_C$) pour un montage Darlington et pour un transistor indépendant ;

la figure 3 représente un circuit selon la présente invention ;

la figure 4 représente plus en détail une partie logique du circuit de la figure 3 ;

la figure 5 représente un circuit de commande de commutation de courant base pouvant être utilisé en relation avec le mode de réalisation de la figure 3 ; et

la figure 6 représente un mode de réalisation particulier de la présente invention constituant une variante des circuits des figures 3, 4 et 5.

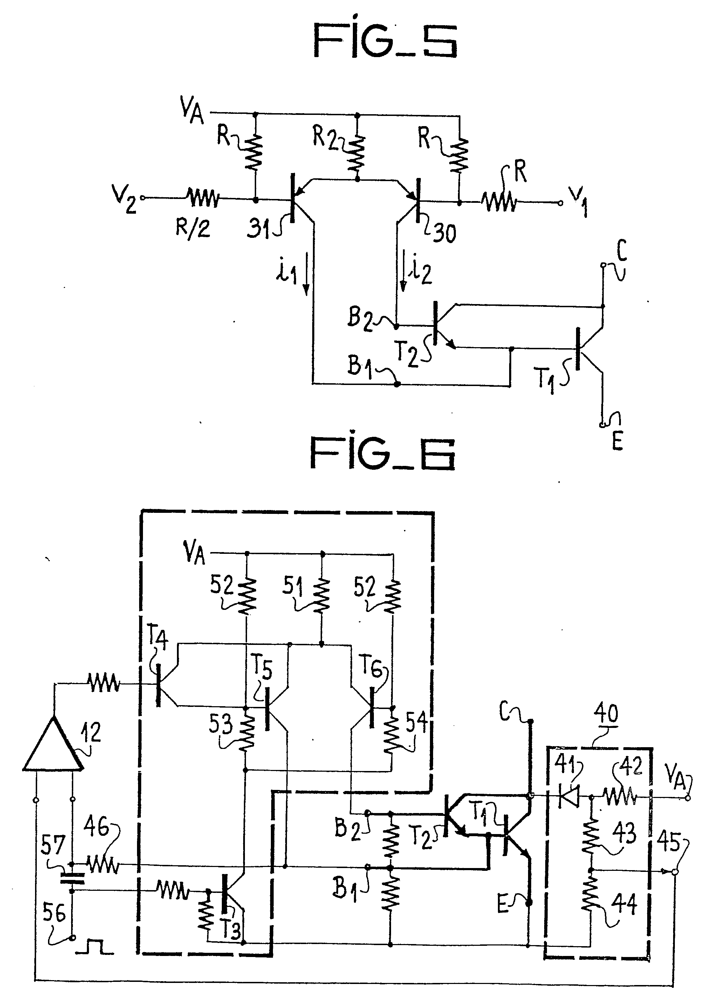

La figure 3 représente un mode de réalisation de la présente invention. On y retrouve les deux transistors $T_1$ et $T_2$ en montage Darlington ainsi que les bornes de collecteur et d'émetteur C et E du montage qui correspondent aux bornes $C_1$ et $E_1$ du transistor $T_1$. La borne de commande B du montage Darlington est maintenant désignée par la référence $B_2$ pour la distinguer de la borne $B_1$ de base du transistor $T_1$ qui est rendue accessible selon la présente invention. Ces bornes $B_1$ et $B_2$ constituent les deux bornes de sortie possibles d'un commutateur 10 recevant à sa borne d'entrée 11 un courant de commande de base. Comme cela a été exposé précédemment, le commutateur 10 établit la liaison entre sa borne d'entrée 11 et sa borne de sortie $B_2$ quand le courant traversant le transistor $T_1$ est supérieur au courant correspondant au point 3 de la figure 2 et entre sa borne d'entrée 11 et sa borne de sortie $B_1$ quand le courant de collecteur est inférieur à cette valeur. Cette détection du courant de collecteur peut être faite de toutes les façons possibles. L'une de ces façons consiste à transmettre la tension de collecteur à une première entrée d'un comparateur 12 dont la deuxième entrée reçoit une tension de référence. Selon que la tension sur le collecteur est supérieure ou inférieure à la tension de référence prédéterminée, un signal est envoyé à un circuit logique 13 comprenant éventuellement d'autres entrées 14 d'inhibition et de remise à zéro pour commander la commutation du commutateur 10.

Selon une variante de la présente invention,

illustrée par des traits en pointillés en figure 3, la deuxième entrée du comparateur 12 peut être connectée à la borne $B_1$. La tension sur cette borne $B_1$ quand le circuit est en conduction est représentée par la courbe en pointillés 4 de la figure 2. On voit que, dès que le courant de collecteur du transistor de puissance $T_1$ est voisin de la valeur correspondant à celle du point 3, la tension collecteur/émetteur du transistor $T_1$ est très voisine de sa tension base/émetteur, c'est-à-dire que la tension $V_{CE}$ est sensiblement égale à la tension $V_{BE}$. Dès que cet état est détecté par le comparateur 12, celui-ci envoie des signaux de validation appropriés au circuit logique 13. Cette variante de réalisation permet de s'affranchir de la fourniture d'une tension de référence à la deuxième borne d'entrée du comparateur 12 et évite ainsi de prévoir un circuit spécifique pour chaque transistor $T_1$ particulier associé à un transistor $T_2$ particulier.

La figure 4 illustre un mode de réalisation du circuit logique 13 de la figure 3. Ce circuit logique comprend une borne d'entrée 20 recevant la sortie de l'amplificateur 12 et la transmettant à une première entrée d'une bascule 21, par exemple une entrée de mise à 1 de cette bascule. L'autre entrée ou entrée de mise à 0 de la bascule 21 est connectée à un circuit de modulation de largeur d'impulsions 22 par l'intermédiaire d'un circuit de retard 23. Le circuit de modulation de largeur d'impulsions 22 commande également la commutation d'une source de courant 24 alimentant la borne d'entrée 11 du commutateur 10 décrit précédemment en relation avec la figure 3. Cette remise à 0 permet de replacer le commutateur à l'état de repos dans la position $B_2$ (borne B du Darlington).

La figure 5 représente un mode de réalisation particulier du commutateur 10. On retrouve en figure 5 les transistors $T_1$ et $T_2$ et les bornes $B_1$, $B_2$, C et E du Darlington selon l'invention. La borne $B_2$ est connectée à une source d'alimentation $V_A$ par l'intermédiaire de la jonction collecteur/émetteur d'un transistor 30 et d'une résistance $R_2$. La borne $B_1$ est connectée à cette même source d'alimentation par l'intermédiaire de la jonction collecteur/émetteur d'un transistor 31 et de la même résistance $R_2$. Des tensions complémentaires $V_1$ et $V_2$ sont appliquées aux bornes de base des transistors respectifs 30 et 31. Ainsi, quand la tension $V_1$ est à bas niveau et la tension $V_2$ à haut niveau, un courant $I_2$ circule vers la base $B_2$ et le circuit fonctionne en Darlington. Par contre, dans l'état inverse, un courant $I_1$ circule vers la base $B_1$ et le transistor $T_1$ fonctionne en circuit indépendant. On notera qu'un avantage de ce schéma particulier réside dans le fait qu'il permet si nécessaire de régler simplement les courants $I_1$ et $I_2$ à des valeurs distinctes et prédéterminées en prévoyant un circuit intermédiaire entre l'une ou l'autre des bornes $B_1$ et $B_2$ et la tension $V_A$.

La présente invention trouve notamment des applications à des hacheurs de commande de moteurs. Pour de tels circuits, on utilise souvent comme « interrupteur » principal du hacheur, un transistor en montage Darlington. En fait, ce montage Darlington est utile uniquement parce que, au démarrage, un appel de courant important se fait sentir. Lors du fonctionnement stable du moteur, le courant nécessaire est beaucoup plus faible et le fonctionnement en transistor de puissance indépendant tel qu'exposé précédemment est préférable. L'avantage de cette commutation du montage type Darlington au montage type transistor indépendant est particulièrement significatif dans cette application spécifique du fait que la période de démarrage est généralement courte devant la période de fonctionnement stable. L'économie d'énergie réalisée est donc importante. Ceci permettra en particulier de réaliser une économie sur le montage du transistor de puissance dont les moyens de refroidissement peuvent être notablement réduits.

## Revendications

1. Procédé de commande d'un montage Darlington comprenant un transistor de puissance et un transistor pilote, caractérisé en ce qu'il comprend les étapes suivantes : détecter le courant de collecteur dans le transistor de puissance, comparer la valeur détectée à une valeur de seuil prédéterminée, et faire fonctionner le transistor de puissance indépendamment du transistor pilote quand ledit courant de collecteur est inférieur à un seuil prédéterminé.

2. Montage de transistors de type Darlington comprenant un transistor de puissance ($T_1$) et un transistor pilote ($T_2$), les collecteurs des deux transistors étant interconnectés et la base du transistor de puissance étant connectée à l'émetteur du transistor pilote, le collecteur et l'émetteur du transistor de puissance constituant les bornes principales du montage et la base du transistor pilote constituant une première borne de commande ($B_2$), caractérisé en ce qu'il comprend en outre : une deuxième borne de commande ($B_1$) reliée à la base du transistor de puissance, un moyen de commutation (10) susceptible de recevoir à sa borne d'entrée (11) un courant de commande et transmettant ce courant soit à la première borne de commande soit à la deuxième borne de commande, un moyen (12) de détection et de comparaison du courant traversant le transistor de puissance, des moyens de commande (13) pour actionner le moyen de commutation vers la première ou la deuxième borne de commande selon que le moyen de détection indique que le courant dans le transistor de puissance est supérieur ou inférieur à un seuil prédéterminé.

3. Montage selon la revendication 2, caractérisé en ce que le moyen de détection et de comparaison détecte la tension de collecteur du transistor de puissance et la compare à une tension fixe prédéterminée.

4. Montage selon la revendication 2, caractérisé en ce que le moyen de détection et de comparaison détecte la tension de collecteur du transistor de puissance et la compare à la tension de base de ce transistor de puissance accessible au niveau de la deuxième borne de commande, le résultat de cette comparaison étant lui-même comparé à une valeur de seuil et transmis aux moyens de commande.

## Claims

1. A process of controlling a Darlington circuit comprising a power transistor and a pilot transistor, characterized in that it includes the following steps : detecting the collector current in the power transistor, comparing the detected value to a predetermined threshold value, and operating the power transistor independently of the pilot transistor, said collector current being lower than a predetermined threshold.

2. A Darlington type transistor circuit comprising a power transistor ($T_1$) and a pilot transistor ($T_2$), the collectors of the two transistors being interconnected and the base of the power transistor being connected to the emitter of the pilot transistor, the collector and the emitter of the power transistor constituting the main terminals of the circuit, and the base of the pilot transistor constituting a first control terminal ($B_2$), characterized in that said circuit further comprises : a second control terminal ($B_1$) connected to the base of the power transistor, a switching means (10) adapted to receive at its input terminal (11) a control current and transmit said current either to the first control terminal or the second control terminal, a means (12) for detecting and comparing the current flowing through the power transistor, control means for actuating the switching means toward the first or the second control terminal, depending on whether the detecting means indicates that the current in the power transistor is higher or lower than a predetermined threshold.

3. A circuit according to claim 2, characterized in that the detecting and comparing means detects the voltage of the collector of the power transistor and compares the same to a fixed predetermined voltage.

4. A circuit according to claim 2, characterized in that the detecting and comparing means detects the collector voltage of the power transistor and compares the same to the base voltage of said power transistor, which is accessible at the level of the second control terminal, the result of this comparison being compared, in turn, to a threshold value and transmitted to the control means.

## Ansprüche

1. Verfahren zum Steuern einer einen Krafttransistor und einen Steuertransistor aufweisenden Darlingtonschaltung, daduch gekennzeichnet, dass es folgende Verfahrensschritte umfasst : Ermitteln des Kollektorstroms im Krafttransistor, Vergleichen des ermittelten Wertes mit einem vorbestimmten Schwellenwert, und Betrieben des Krafttransistors unabhängig vom Steuertransistor, wenn der genannte Kollektorstrom niedriger als eine vorbestimmte Schwelle ist.

2. Transistorschaltung vom Typ Darlington mit einem Krafttransistor ($T_1$) und einem Steuertransistor ($T_2$), wobei die Kollektoren der beiden Transistoren miteinander verbunden sind und die Basis des Krafttransistors mit dem Ermittler des Steuertransistors verbunden ist, der Kollektor und der Emitter des Krafttransistors die Hauptanschlussklemmen der Schaltung bilden und die Basis des Steuertransistors eine erste Steueranschlussklemme ($B_2$) bildet, dadurch gekennzeichnet, dass die Schaltung ferner umfasst : Eine mit der Basis des Krafttransistors verbundene zweite Steueranschlussklemme ($B_1$) ein Umschaltmittel (10), derart ausgestaltet, dass es an seiner Eingangsklemme (11) einen Steuerstrom empfangen kann und denselben entweder an die erste oder an die zweite Steueranschlussklemme überträgt, ein Mittel (12) zum Ermitteln und Vergleichen des durch den Krafttransistor fliessenden Stromes, Steuermittel (13) zur Betätigung des Umschaltmittels zwecks Anschliessens an die erste oder die zweite Steueranschlussklemme, je nachdem ob das Stromabnahmemittel anzeigt, dass der im Krafttransistor fliessende Strom höher oder tiefer liegt, als ein vorbestimmter Schwellenwert.

3. Schaltung nach Anspruch 2, dadurch gekennzeichnet, dass das Stromabnahme- und Vergleichsmittel die Kollektorspannung des Krafttransistors abnimmt und mit einer unverändlichen, vorbestimmten Spannung vergleicht.

4. Schaltung nach Anspruch 2, dadurch gekennzeichnet, dass das Stromabnahme- und Vergleichsmittel die Kollektorspannung des Krafttransistors abnimmt und mit der an der zweiten Steueranschlussklemme zugänglichen Basisspannung dieses Krafttransistors vergleicht, wobei das Ergebnis dieses Vergleiches seinerseits mit einem Schwellenwert verglichen und an die Steuermittel übertragen wird.

FIG_1

FIG_2

FIG_3

FIG_4

0 029 767

# FIG_5

# FIG_6

2